# FASCICULE DE BREVET EUROPEEN

(11) **EP 2 035 852 B1**
(45) Date de publication et mention de la délivrance du brevet: **14.03.2012**
(21) Numéro de dépôt: 07803925.2
(22) Date de dépôt: 22.06.2007
(51) Int. Cl.: G01R 33/32, G01R 33/34, G01R 33/09, G01R 33/035, B82Y 25/00

(54) **SYSTEME DE MESURE D'UN SIGNAL DE RESONANCE MAGNETIQUE A BASE D'UN CAPTEUR HYBRIDE SUPRACONDUCTEUR-MAGNETORESISTIF**
VORRICHTUNG UND VERFAHREN ZUR MESSUNG EINES MAGNETRESONANZSIGNALS MITTELS EINES EINEN SUPRALEITER UND EIN MAGNETORESISTIVES ELEMENT ENTHALTENDEN HYBRIDSENSORS
SYSTEM AND METHOD FOR MEASURING A MAGNETIC RESONANCE SIGNAL BY MEANS OF A HYBRID-SENSOR CONTAINING A SUPERCONDUCTOR AND A MAGNETORESISTIVE ELEMENT

(30) Priorité: 22.06.2006 FR 0652599
(43) Date de publication de la demande: 18.03.2009
(73) Titulaire: Commissariat à l'Énergie Atomique et aux Énergies Alternatives, 75015 Paris (FR)
(72) Inventeur: FERMON, Claude, F-91400 Orsay (FR); JACQUINOT, Jacques, F-75013 Paris (FR); PANNETIER-LECOEUR, Myriam, F-91440 Bures Sur Yvette (FR); SCOLA, Joseph, 75018 Paris (FR)
(74) Mandataire: Thévenet, Jean-Bruno
(86) Numéro de dépôt international: PCT/FR2007/051502
(87) Numéro de publication internationale: WO 2007/148029

(56) Documents cités:
- WO-A-2004/068152
- US-A1- 4 875 010
- PANNETIER M ET AL: "Femtotesla magnetic field measurement with magnetoresistive sensors" SCIENCE AMERICAN ASSOC. ADV. SCI USA, vol. 304, no. 5677, 11 juin 2004 (2004-06-11), pages 1648-1650, XP002423293 ISSN: 0036-8075
- BLUEMICH B ET AL: "THE NMR-MOUSE: CONSTRUCTION, EXCITATION, AND APPLICATIONS" MAGNETIC RESONANCE IMAGING, TARRYTOWN, NY, US, vol. 16, no. 5/6, juin 1998 (1998-06), pages 479-484, XP000918278 ISSN: 0730-725X
- WURM MARTIN ET AL: "Longitudinal detection of pulsed low-frequency, low-temperature nuclear magnetic resonance using a dc SQUID" REVIEW OF SCIENTIFIC INSTRUMENTS, AMERICAN INSTITUTE OF PHYSICS, US, vol. 69, no. 3, mars 1998 (1998-03), pages 1456-1462, XP012036476 ISSN: 0034-6748
- GREENBERG YA S: "Application of superconducting quantum interference devices to nuclear magnetic resonance" REVIEWS OF MODERN PHYSICS, AMERICAN PHYSICAL SOCIETY, US, vol. 70, no. 1, janvier 1998 (1998-01), pages 175-222, XP002322254 ISSN: 0034-6861
- PANNETIER ET AL: "Ultra-sensitive mixed sensors-Design and performance" SENSORS AND ACTUATORS A, ELSEVIER SEQUOIA S.A., LAUSANNE, CH, vol. 129, no. 1-2, 24 mai 2006 (2006-05-24), pages 247-250, XP005427242 ISSN: 0924-4247

## Description

La présente invention a pour objet un procédé et un système de mesure d'un signal de résonance magnétique.

La résonance magnétique nucléaire (RMN) est largement utilisée en physique, chimie et biologie pour la caractérisation des matériaux et des molécules à travers la réponse des noyaux à une excitation magnétique radiofréquence. Plus récemment, des techniques d'imagerie par résonance magnétique (IRM) basées sur ce principe se sont largement développées et sont couramment utilisées dans le domaine médical.

Jusqu'à présent, la RMN est toujours réalisée sur le principe de la mise en oeuvre d'une ou de deux bobines accordées à la fréquence de résonance des noyaux que l'on cherche à détecter.

Des impulsions de radiofréquence sont envoyées sur l'échantillon ou le patient, suivant des séquences prédéfinies et un signal, correspondant à la réponse des noyaux observés est détecté dans la même bobine ou une seconde bobine située à 90° de la première. La fréquence de travail est donnée par un champ magnétique extérieur multiplié par un facteur gyromagnétique qui est caractéristique de chaque atome.

La limite de sensibilité d'un spectromètre RMN est donnée par le bruit thermique associé à la bobine de résonance et au bruit du préamplificateur associé. Pour cette raison, un certain nombre de chercheurs ont proposé d'utiliser des bobines refroidies qui permettent de réduire le bruit thermique associé à la bobine.

Une limitation intrinsèque de la détection avec une bobine de résonance provient du fait que la tension mesurée aux bornes du circuit accordé décroît comme la fréquence que l'on cherche à détecter. Ainsi à bas champ et donc à faible fréquence, la sensibilité d'une bobine de résonance devient faible.

Des chercheurs ont proposé d'utiliser des capteurs à base de détecteurs supraconducteurs dénommés "SQUID" (Superconducting Quantum Interference Device : détecteur supraconducteur à interférence quantique) qui présentent une sensibilité excellente à basse fréquence pour détecter le signal de RMN. Mais les SQUIDs présentent le désavantage d'être très sensibles à l'application d'impulsions de radiofréquence intenses.

Des premières versions de capteurs hybrides ont été proposées dans les documents de brevets WO 2004/068152 A1 et WO 2004/068158 A1 ainsi que dans l'article de Pannetier M. et al intitulé "Femto-tesla Magnetic Field Measurement with Magnetoresistive Sensors" publié dans SCIENCE, 11.06.2004, Vol. 304. Les capteurs décrits dans ces documents comportent une boucle supraconductrice associée à un capteur de type magnétorésistif. L'axe de sensibilité d'un capteur mixte est perpendiculaire à la boucle supraconductrice.

La présente invention vise à permettre d'effectuer la mesure d'un signal de résonance magnétique d'une façon plus commode et plus efficace que selon les méthodes traditionnelles, avec une excellente sensibilité sur une gamme étendue de mesure.

Ces buts sont atteints conformément à l'invention, grâce à un système de mesure d'un signal de résonance magnétique au sein d'un échantillon placé dans un champ magnétique extérieur statique, comprenant un dispositif d'excitation pour appliquer des impulsions radiofréquence de forte intensité à une fréquence d'émission prédéterminée fₑ dans une zone de mesure contenant l'échantillon, le dispositif d'excitation comprenant une bobine d'excitation raccordée à ladite fréquence d'émission prédéterminée fₑ et disposée au voisinage de l'échantillon de manière à émettre un champ électromagnétique essentiellement perpendiculaire au champ magnétique extérieur statique, et

au moins un capteur hybride supraconducteur-magnétorésistif comprenant une boucle supraconductrice munie d'une constriction apte à augmenter significativement la densité du courant et au moins un capteur magnétorésistif placé à proximité immédiate de ladite constriction, en étant séparé de celle-ci par un dépôt isolant, caractérisé en ce que ledit capteur magnétorésistif et ladite constriction sont recouverts d'au moins une couche de matériau métallique non supraconducteur afin de servir de réservoir thermique et de réaliser une protection contre la destruction par des impulsions de radiofréquence, ladite au moins une couche (75) de matériau métallique non supraconducteur ne recouvrant que ladite constriction (72) et non le reste de la boucle supraconductrice (71).

Dans la suite de la description, le terme "échantillon" désignera tout objet ou patient soumis à une excitation magnétique radiofréquence.

Selon un mode particulier de réalisation, le capteur hybride supraconducteur-magnétorésistif comprend au moins deux capteurs magnétorésistifs montés en demi-pont de Wheatstone.

Dans ce cas, avantageusement, chaque paire de capteurs hybrides montés en demi-pont de Wheatstone est en outre connectée à un préamplificateur basse fréquence additionnel lui-même connecté à un filtre, de manière à permettre d'effectuer, à l'aide des mêmes capteurs, une mesure de champ magnétique à fréquence faible à côté d'une mesure de résonance magnétique.

Les capteurs magnétorésistifs peuvent être alimentés en courant continu ou en courant alternatif.

Selon un mode particulier de réalisation, chaque capteur magnétorésistif est alimenté par un courant alternatif à une fréquence prédéterminée f_{cap} différente de ladite fréquence d'émission prédéterminée fₑ.

Dans ce cas, de préférence, la différence de fréquence entre la fréquence f_{cap} du courant appliqué à chaque capteur magnétorésistif et la fréquence fᵣ de résonance de l'échantillon est constante.

Selon un mode de réalisation particulier qui est adapté à la mesure en champ magnétique faible, le capteur hybride est placé directement au voisinage de l'échantillon.

Dans ce cas, de préférence, l'axe de sensibilité du capteur est placé perpendiculairement au champ créé par la bobine d'excitation.

Selon un autre mode de réalisation particulier, qui est bien adapté à la mesure en champ magnétique fort le capteur hybride est couplé à l'échantillon au travers d'un transformateur de flux.

De préférence, le transformateur de flux est au moins partiellement supraconducteur.

Le transformateur de flux comprend une boucle secondaire qui entoure l'échantillon ou est disposée à proximité immédiate de l'échantillon.

Avantageusement, le transformateur de flux comprend une boucle secondaire qui est placée perpendiculairement à la bobine d'excitation.

Selon un mode de réalisation préférentiel, le transformateur de flux comprend une boucle primaire qui est placée parallèlement à la boucle supraconductrice du capteur hybride et présente une taille équivalente à celle-ci.

Lorsque le transformateur de flux est au moins partiellement supraconducteur, la boucle primaire et la boucle supraconductrice du capteur hybride sont disposées dans une enceinte refroidie.

Selon une variante de réalisation, le transformateur de flux comprend une boucle primaire qui est constituée directement par la boucle supraconductrice du capteur hybride.

Selon encore un autre mode de réalisation, le système de mesure d'un signal de résonance magnétique comprend un capteur hybride double monté en gradiomètre comportant des premier et deuxième capteurs hybrides disposés de telle sorte que leurs axes de sensibilité respectifs soient symétriques par rapport à la bobine d'excitation et perpendiculaires au champ créé par celle-ci, et l'un des premier et deuxième capteurs hybrides étant placé à proximité immédiate de l'échantillon.

Selon un mode de réalisation particulier le dispositif d'excitation comprend des moyens d'émission à plusieurs canaux pour émettre des impulsions radiofréquence de forte intensité avec une pluralité de fréquences d'émission prédéterminées fₑ₁, fₑ₂, fₑ₃ vers la bobine d'excitation qui est du type à accord multiple de façon à pouvoir être accordée sur l'une quelconque desdites fréquences d'émission prédéterminées fₑ₁, fₑ₂, fₑ₃.

Selon encore un autre mode de réalisation particulier, l'échantillon est constitué par une surface en regard de laquelle sont disposés des aimants permanents pour créer ledit champ magnétique statique dans un volume déterminé, e la bobine d'excitation est disposée parallèlement à ladite surface au voisinage dudit volume déterminé, et le capteur hybride est disposé au voisinage de ladite bobine d'excitation, parallèlement à celle-ci, en étant séparé de celle-ci par une paroi et un espace vide d'isolement.

Selon un exemple de réalisation préférentiel, le dispositif d'excitation comprend un dispositif de synthèse de fréquence pour émettre un signal radiofréquence à une fréquence d'émission fₑ, un séquenceur pour émettre des impulsions de hachage du signal radiofréquence, un module d'émission relié au dispositif de synthèse de fréquence et au séquenceur pour émettre lesdites impulsions radiofréquence de forte intensité avec ladite fréquence d'émission prédéterminée fₑ, un circuit de protection pour appliquer lesdites impulsions à la bobine d'excitation, un préamplificateur recevant le signal à la fréquence de résonance fᵣ très proche de la fréquence d'émission fₑ, capté par le capteur hybride, un circuit de démodulation recevant d'une part les impulsions émises à la fréquence d'émission fₑ à partir du séquenceur et du dispositif de synthèse de fréquences et d'autre part les impulsions reçues à la fréquence de résonance fᵣ délivrées par le préamplificateur, et un dispositif d'acquisition pour récupérer un signal de sortie à la fréquence fₑ + fᵣ ou fₑ - fᵣ.

Le système selon l'invention peut comprendre une pluralité de capteurs hybrides.

Dans ce cas, selon un mode particulier de réalisation, le système comprend une bobine d'excitation unique, et chaque capteur hybride permet de récupérer un signal utile avec un préamplificateur individuel.

Selon l'invention, chaque capteur hybride peut en outre être connecté à un préamplificateur basse fréquence additionnel lui-même connecté à un filtre, de manière à permettre d'effectuer à l'aide des mêmes capteurs une mesure de champ magnétique à fréquence faible à côté d'une mesure de résonance magnétique.

Dans ce cas, selon une variante de réalisation, les capteurs magnétorésistifs des capteurs hybrides sont alimentés en courant continu et le filtre est un filtre passe-bas.

Selon une autre variante de réalisation les capteurs magnétorésistifs des capteurs hybrides sont alimentés en courant alternatif et le filtre est un filtre passe-bande centré sur la fréquence dudit courant alternatif.

Les capteurs magnétorésistifs des capteurs hybrides sont choisis parmi les capteurs à effet Hall, les capteurs à magnétorésistance anisotrope (AMR), les capteurs à magnétorésistance géante (GMR), les capteurs à magnétorésistance tunnel (TMR), les capteurs à magnétorésistance colossale (CMR).

L'invention a également pour objet un procédé de mesure d'un signal de résonance magnétique au sein d'un échantillon placé dans un champ magnétique extérieur statique selon lequel on applique des impulsions radiofréquence de forte intensité à une fréquence d'émission prédéterminée fₑ dans une zone de mesure contenant l'échantillon, à une bobine d'excitation accordée à ladite fréquence d'émission prédéterminée fₑ et disposée au voisinage de l'échantillon de manière à émettre un champ électromagnétique essentiellement perpendiculaire au champ magnétique extérieur statique, et
on détecte un signal de résonance magnétique à l'aide d'au moins un capteur hybride supraconducteur-magnétorésistif comprenant une boucle supraconductrice munie d'au moins une constriction et au moins un capteur magnétorésistif placé à proximité immédiate de ladite constriction en étant séparé de celle-ci par une couche isolante, caractérisé en ce que ledit capteur magnétorésistif et ladite constriction sont recouverts d'au moins une couche de matériau métallique non supraconducteur afin de servir de réservoir thermique et de réaliser une protection contre la destruction par des impulsions de radiofréquence, ladite au moins une couche (75) de matériau métallique non supraconducteur ne recouvrant que ladite constriction (72) et non le reste de la boucle supraconductrice (71).

D'autres caractéristiques et avantages de l'invention ressortiront de la description suivante de modes particuliers de réalisation, donnés à titre d'exemples, en référence aux dessins annexés, sur lesquels :
- la Figure 1 est un schéma-bloc d'ensemble montrant un premier exemple de spectromètre RMN selon l'invention à base de capteurs hybrides, adapté à des mesures en champ faible,
- la Figure 2 est une vue schématique montrant un exemple de circuits électroniques connectés à un ensemble de deux capteurs magnétorésistifs utilisables dans un appareil selon l'invention,
- la Figure 3 est un schéma-bloc d'ensemble montrant un deuxième exemple de spectromètre RMN selon l'invention à base de capteurs hybrides, équipé d'un transformateur de flux/flux et adapté à des mesures en champ fort,
- la Figure 4 est un schéma-bloc d'ensemble montrant une variante de réalisation d'un spectromètre RMN avec plusieurs fréquences d'émission,
- la figure 5 est une vue schématique d'un autre exemple de réalisation de l'invention adapté pour de la RMN de surface,
- la Figure 6 est un schéma-bloc d'ensemble montrant une variante de réalisation d'un spectromètre RMN avec des capteurs magnétorésistifs alimentés en courant alternatif,
- la Figure 7 est une vue schématique d'un exemple de capteur hybride protégé par une couche métallique utilisable dans le cadre de l'invention,
- la Figure 7a est une coupe selon la ligne VIIA-VIIA de la Figure 7,
- la Figure 8 est une vue schématique d'un mode particulier de réalisation de l'invention montrant une configuration où le capteur hybride est monté en gradiomètre et l'échantillon se trouve dans l'une des boucles du gradiomètre,
- la Figure 9 est une vue schématique d'un mode particulier de réalisation de l'invention montrant une configuration où un transformateur de flux/flux est combiné avec un transformateur de flux/champ,
- la Figure 10 est une vue schématique d'ensemble montrant un exemple de réalisation d'un spectromètre RMN avec un ensemble de plusieurs capteurs hybrides, et
- la Figure 11 est un schéma-bloc montrant un mode particulier de réalisation selon une configuration d'imagerie qui combine imagerie par résonance magnétique et imagerie magnétique à basse fréquence.

La résonance magnétique inclut de façon non exclusive la résonance magnétique nucléaire, la résonance quadrupolaire nucléaire, la résonance paramagnétique électronique et la résonance ferromagnétique. Dans la suite de la description de l'invention, il sera fait référence à la résonance magnétique nucléaire qui est l'application la plus répandue. Les modifications pour les autres types de résonance sont faibles.

Lors d'une expérience de Résonance Magnétique Nucléaire (RMN), des impulsions radiofréquence de forte intensité sont envoyées sur l'échantillon placé dans un champ magnétique extérieur qui peut être simplement le champ terrestre ou un champ magnétique homogène créé par une bobine ou des aimants permanents. Ces impulsions tournent l'aimantation des spins nucléaires observés qui se mettent alors à adopter un mouvement de précession à une fréquence donnée par le produit du champ magnétique et du rapport gyromagnétique caractéristique de chaque noyau. (42MHz/T pour l'atome d'hydrogène). Les impulsions de radiofréquence engendrent des champs de l'ordre de quelques milliTesla ce qui correspond à des puissances pouvant atteindre plusieurs kW durant des temps pouvant atteindre la milliseconde.

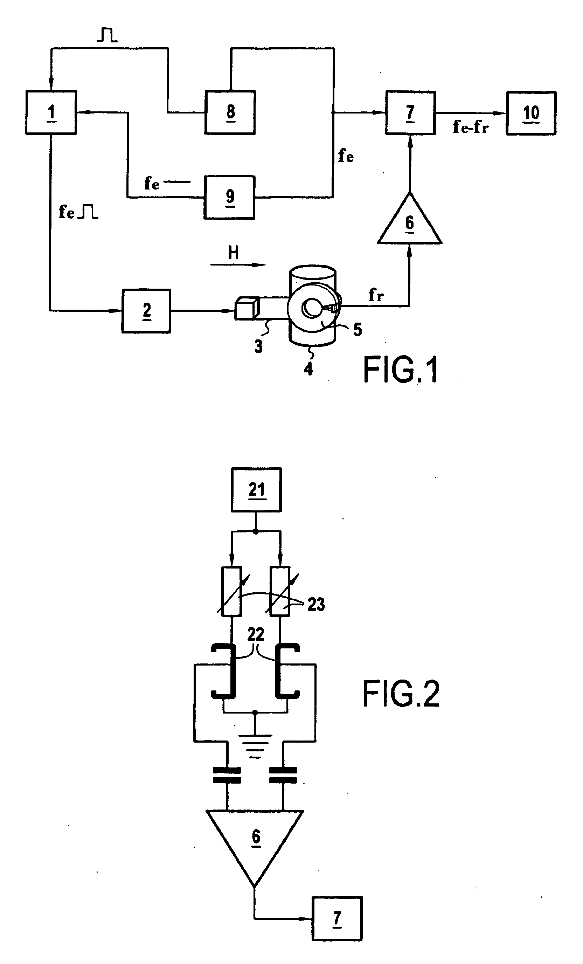

Le principe d'un spectromètre RMN permettant de réaliser une mesure avec un capteur hybride conformément à l'invention sera décrit d'abord en référence à l'exemple de réalisation de la Figure 1.

Un dispositif d'excitation permet de créer un signal de radiofréquence à une fréquence prédéterminée fₑ réglable en phase et en amplitude.

Un dispositif de synthèse de fréquence 9 permet l'émission d'un signal radiofréquence à une fréquence d'émission fₑ. Un séquenceur 8 engendre des impulsions qui viennent hacher le signal radiofréquence produit par le dispositif 9 de synthèse de fréquence.

Un module d'émission 1 est relié à la fois au dispositif de synthèse de fréquence 9 et au séquenceur 8 pour émettre des impulsions radiofréquence de forte intensité avec la fréquence d'émission prédéterminée fₑ, à travers un circuit de protection 2 qui peut être formé de diodes tête-bêche, vers une bobine d'excitation 3 qui est en général accordée à la fréquence de travail afin de maximiser l'amplitude des impulsions.

La bobine d'excitation est construite afin de pouvoir contenir l'échantillon à mesurer 4, qui peut être un objet ou un patient, et est montée de façon à émettre un champ perpendiculaire au champ magnétique statique H.

Conformément à l'invention, un capteur hybride supraconducteur-magnétorésistif 5 est utilisé pour récupérer le signal émis par la précession des noyaux de l'échantillon 4 à une fréquence de résonance fᵣ très proche de la fréquence d'émission fₑ.

Dans le cas du mode de réalisation de la Figure 1, qui est adapté à la mesure en champ magnétique faible, c'est-à-dire en champ statique tel que le capteur n'est pas saturé, le capteur 5 peut être directement mis en contact de l'échantillon 4.

De préférence, le capteur hybride 5 est disposé de telle façon que son axe sensible soit perpendiculaire au champ créé par la bobine d'excitation 3 et perpendiculaire au champ magnétique statique H.

Les magnétorésistances du capteur hybride 5 détectent le signal à la fréquence fᵣ et sont connectées à un préamplificateur à bas bruit 6 qui permet d'attaquer un circuit de réception 7 travaillant en démodulation.

Le circuit de démodulation 7 reçoit ainsi d'une part les impulsions émises à la fréquence d'émission fₑ à partir du séquenceur 8 et du dispositif de synthèse de fréquence 9 et d'autre part les impulsions reçues à la fréquence de résonance fᵣ délivrées par le préamplificateur 6.

Le séquenceur 8 contrôle ainsi à la fois l'émission et la réception qui sont alimentées par un circuit 9 de synthèse de fréquence commun.

Un dispositif d'acquisition 10 permet de récupérer un signal de sortie à la fréquence fₑ - fᵣ ou fₑ + fᵣ.

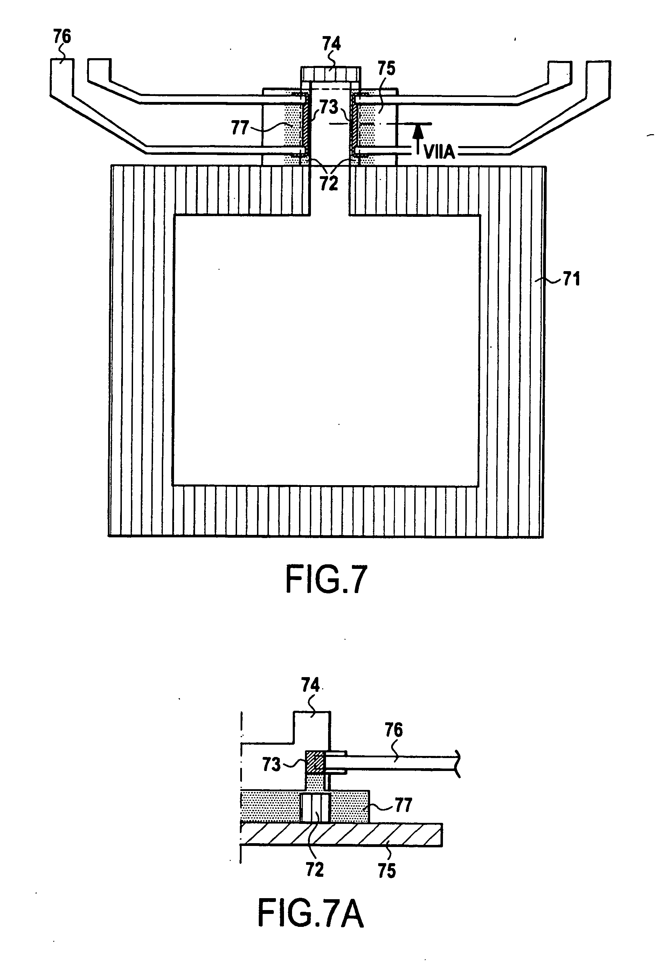

Le capteur hybride supraconducteur-magnétorésistif 5 comprend une boucle supraconductrice 71 munie d'au moins une constriction 72 et au moins un capteur magnétorésistif 73 placé à proximité immédiate de la constriction 72 (voir Figure 7).

La constriction 72 correspond à une réduction de section de la boucle supraconductrice 71 dans une mesure suffisante pour augmenter significativement la densité de courant.

D'une manière générale, le principe d'un capteur hybride est de contenir un transformateur de flux/champ qui est composé d'une grande boucle de capture 71 associée à une ou plusieurs constrictions 72 de quelques micromètres de large. Sur les constrictions sont placés un ou plusieurs capteurs magnétorésistifs 73 qui peuvent être des capteurs à effet Hall, des capteurs à magnétorésistance anisotrope (AMR), à magnétorésistance géante (GMR), à magnétorésistance tunnel (TMR) ou à magnétorésistance colossale (CMR). Les capteurs 73 sont séparés de la couche supraconductrice 72 par un dépôt isolant comme du Si O₂ ou du Si₃ N₄.

La mesure du ou des capteurs magnétorésistifs est réalisée à travers des contacts métalliques 76 qui peuvent être par exemple en or ou en cuivre protégé par du tantale.

Lorsque le transformateur flux/champ est soumis aux impulsions RF, des courants de plusieurs ampères sont engendrés induisant une transition vers l'état normal de la constriction suivi d'un échauffement violent de celle-ci. Si l'impulsion est suffisamment intense, il s'ensuit la destruction de celle-ci. A titre d'exemple, une impulsion de 400W détruit une constriction de *spm de large et de 100nm d'épaisseur.

Le capteur hybride doit donc être dessiné pour d'une part pouvoir travailler jusqu'à des fréquences assez élevées et d'autre part pouvoir résister aux impulsions de radiofréquence.

La première condition est réalisée en utilisant préférentiellement un support de capteur isolant comme du saphir. Dans ce cas là, on peut obtenir une réponse de capteur hybride uniforme jusqu'à des fréquences de plus de 100N1Hz.

Pour obtenir un capteur hybride qui résiste aux impulsions, il sera avantageux de dessiner la boucle supraconductrice de telle sorte qu'elle soit de grande largeur en dehors de la constriction afin d'une part d'optimiser la sensibilité du capteur et d'autre part de servir de réservoir de chaleur capable d'évacuer rapidement la puissance de l'impulsion. Un calcul d'optimisation basé sur le calcul du gain du transformateur flux/champ et d'autre part sur un calcul suivant une méthode d'éléments finis de la chaleur engendrée par une impulsion de radiofréquence donne une largeur de boucle égale à 0,7 fois le rayon de la boucle. Mais des largeurs de boucle comprises entre 0,1 et 0,9 fois le rayon peuvent fonctionner. Le calcul montre aussi qu'une surface supraconductrice 74 assez grande de part et d'autre de la constriction 72 permet aussi de mieux évacuer la chaleur lors de l'impulsion.

Dans le cas d'impulsions fortes (qui dépassent 400W), une protection supplémentaire peut être créée en recouvrant la constriction et les capteurs magnétorésistifs d'une couche métallique non supraconductrice 75. Cette couche métallique supplémentaire ne doit pas recouvrir la boucle principale mais juste la zone des constrictions. Cette couche a deux fonctions.

La première fonction est de servir de réservoir thermique. On choisit avantageusement un métal ayant une résistivité faible et une bonne conductivité thermique comme le cuivre ou l'aluminium. Cette couche métallique peut être en contact ohmique avec le supraconducteur mais ne doit pas être en contact électrique avec les capteurs. Lorsque la boucle est supraconductrice, l'ensemble du super-courant passe à travers la boucle et lorsque la constriction arrive au courant critique (au début de l'impulsion), le courant peut s'évacuer dans la couche métallique adjacente qui sert de réservoir thermostatique pour la constriction.

La deuxième fonction est de servir de protection électromagnétique. La couche métallique 75 est alors placée de telle sorte qu'elle fasse écran à la bobine d'émission. Son épaisseur doit être plus grande que l'épaisseur de peau à la fréquence de travail.

Dans le cas d'une application à la mesure en champ faible, comme selon la Figure 1, la taille de la boucle supraconductrice 71 du capteur hybride 5 doit être adaptée à l'objet à mesurer.

Le supraconducteur utilisé pourra être de la famille des oxydes à haute température critique comme par exemple YbaCuO, ayant une température de transition au dessus de 77K. Le capteur 5 est séparé de l'échantillon par une paroi non métallique et un vide d'isolement le plus faible possible. Le capteur 5 est relié à une source de refroidissement qui peut être de l'azote liquide. Il peut être directement plongé dans le liquide cryogénique. La bobine d'excitation est placée perpendiculairement à la boucle du capteur si cela est possible et perpendiculairement au champ magnétique statique H. Cette configuration s'applique en particulier à la résonance quadrupolaire nucléaire et à la résonance magnétique nucléaire en champ terrestre.

Le capteur hybride 5 peut par exemple être réalisé selon les dispositions prévues dans le document WO 2004/068158 A1.

De façon plus particulière, comme représenté sur la Figure 2, un capteur hybride destiné à la RMN peut être formé de deux capteurs 22 montés en demi-pont de Wheatstone. Cela permet d'une part de s'affranchir des fluctuations de température et de champ magnétique global et d'autre part d'avoir un signal de sortie nul en absence de signal de précession.

La lecture du signal aux bornes des capteurs magnétorésistifs 22 est une mesure de résistance qui sera avantageusement faite en 4 pointes. Chaque capteur est alors alimenté par une source de courant 21 avec des résistances d'équilibrage 23 et la tension est mesurée et amplifiée par le préamplificateur 6. Le préamplificateur est spécifiquement choisi pour avoir un bruit minimal pour une résistance égale à la résistance du ou des capteurs magnétorésistifs.

L'invention s'applique aussi à la mesure en champ relativement fort, typiquement supérieur à 1 mT.

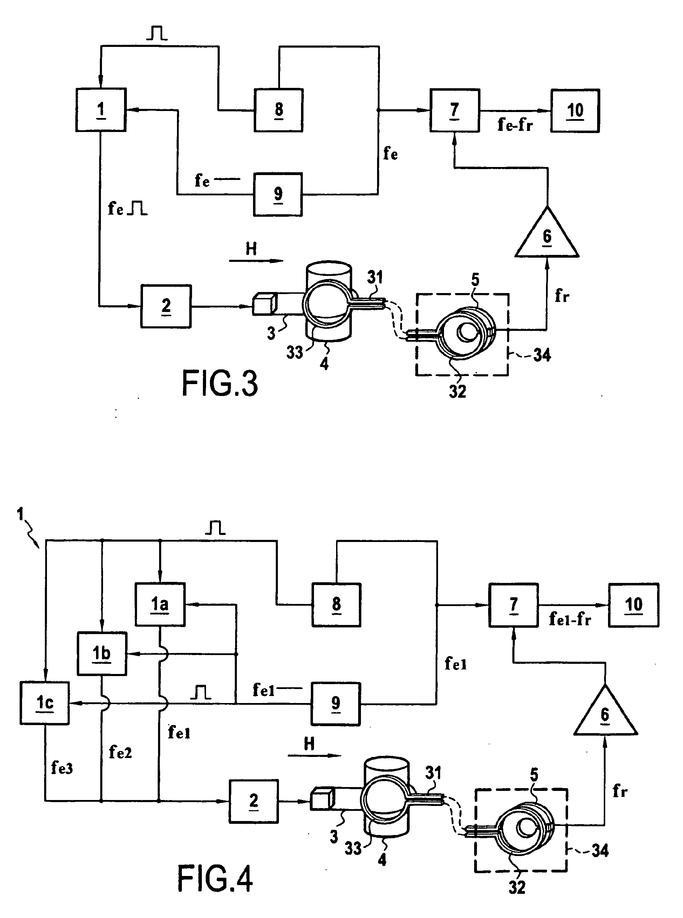

Dans ce cas, comme illustré sur la Figure 3, le capteur hybride 5 n'est pas placé au voisinage immédiat de l'échantillon 4, mais est couplé à celui-ci à travers un transformateur de flux/flux 31 qui sera dénommé par la suite simplement transformateur de flux.

Le transformateur de flux 31 permet de maintenir le capteur hybride loin du champ magnétique statique H dans lequel se fait la mesure et permet d'éviter que le capteur magnétorésistif soit saturé par ce champ magnétique statique.

Le transformateur de flux 31 peut être formé de deux boucles 32, 33 reliées entre elles.

La première boucle 32 (primaire) est superposée à la boucle supraconductrice du capteur hybride 5, l'ensemble de ces deux boucles étant situé dans une enceinte refroidie 34.

La deuxième boucle 33 (secondaire) entoure l'échantillon 4 ou est placée à proximité immédiate de celui-ci.

Le transformateur flux/flux 31 peut être supraconducteur, normal ou partiellement supraconducteur. La taille du primaire 32 doit être prise égale à la taille de la boucle 71 du capteur hybride 5. La taille du secondaire 33 doit être telle qu'elle puisse contenir l'échantillon 4 à mesurer. Le rapport du nombre de tours entre le primaire 32 et le secondaire 33 doit être tel que les inductances de chaque côté soient égales. Dans le cas d'un transformateur de flux 31 supraconducteur, la température critique de ce dernier sera avantageusement proche ou plus haute que celle du capteur hybride. Un transformateur flux/flux 31 supraconducteur présente l'avantage de ne pas être bruyant alors qu'un transformateur flux/flux normal présente un bruit thermique associé à sa résistance. De plus, le transformateur flux/flux normal présente une efficacité qui diminue à basse fréquence. Il est alors important de minimiser la résistance de celui-ci en utilisant soit des fils de gros diamètre, soit des fils multibrins isolés qui présentent l'avantage d'une résistance plus faible à haute fréquence. Le primaire 32, proche du capteur hybride, sera avantageusement formé d'un supraconducteur en veillant à avoir des résistances de contact faibles.

Le capteur 5 est placé dans une enceinte refroidie afin de rendre sa boucle 71 supraconductrice.

On utilisera avantageusement un supraconducteur à haute température qui permet de travailler jusqu'à 85K ou bien d'obtenir une meilleure sensibilité à très basse température. La chambre refroidie 34 contenant le capteur est magnétiquement blindée pour limiter le bruit parasite.

Cette chambre 34 comporte les sorties nécessaires : celle du transformateur de flux 31, l'alimentation en courant des capteurs magnétorésistifs et la lecture de la tension aux bornes des capteurs magnétorésistifs. Le primaire 32 du transformateur de flux 31 est mis en vis-à-vis de la boucle 71 du capteur hybride 5. Le primaire 32 et la boucle 71 de capture du capteur hybride 5 sont avantageusement de la même taille. Le primaire 32 peut avoir un diamètre primaire 32 plus faible que le diamètre intérieur de la boucle de capture 71.

Le secondaire 33 du transformateur de flux 31 entoure l'échantillon 4 de préférence avec une configuration dite en selle de cheval. Il est relié au primaire 32 par un fil torsadé afin d'éviter les boucles supplémentaires. Le transformateur de flux 31 doit être fabriqué avec du fil assez gros ou multibrins afin d'avoir la résistance la plus faible possible. Le diamètre du secondaire 32 est donné par la taille de l'échantillon 4 à mesurer.

Le secondaire 33 du transformateur de flux 31 est placé orthogonalement au champ magnétique principal H. La bobine d'excitation 3 est placée à la fois orthogonalement au champ magnétique principal H et au secondaire 33 du transformateur de flux 31.

Le capteur hybride 5 peut aussi avoir la configuration déjà décrite en référence à la Figure 7. Afin de maximiser le signal sur bruit, il est souhaitable d'utiliser des capteurs magnétorésistifs présentant une résistance assez grande. Une résistance de 3 kOhms est optimale mais elle peut varier entre 100 Ohms et 20 kOhms sans problème. De plus, comme indiqué plus haut, un montage en demi-pont tel qu'illustré sur la Figure 2 est souhaitable car il permet de s'affranchir des fluctuations de température ou dues à la présence de champs magnétiques planaires. L'exemple donné est celui de capteurs de type GMR montés en demi-pont. Chaque capteur a une longueur de 1 mm et est alimenté par des lignes de courant. Deux lignes de tension permettent de mesurer la résistance. Les deux capteurs GMR sont construits de manière à répondre de façon identique à la présence d'un champ extérieur. La différence de tension entre les deux capteurs est mesurée par le préamplificateur monté en différentiel comme indiqué sur la Figure 2. Les capteurs sont alimentés avec une source de courant alternative donnée par f_{cap} = fₑ + f_{loc} où f_{loc} est la fréquence de travail de la réception. On pourra choisir une fréquence assez basse, comme 77 KHz, qui permet d'utiliser des amplificateurs opérationnels très faibles bien adaptés pour une résistance de 3 kOhms.

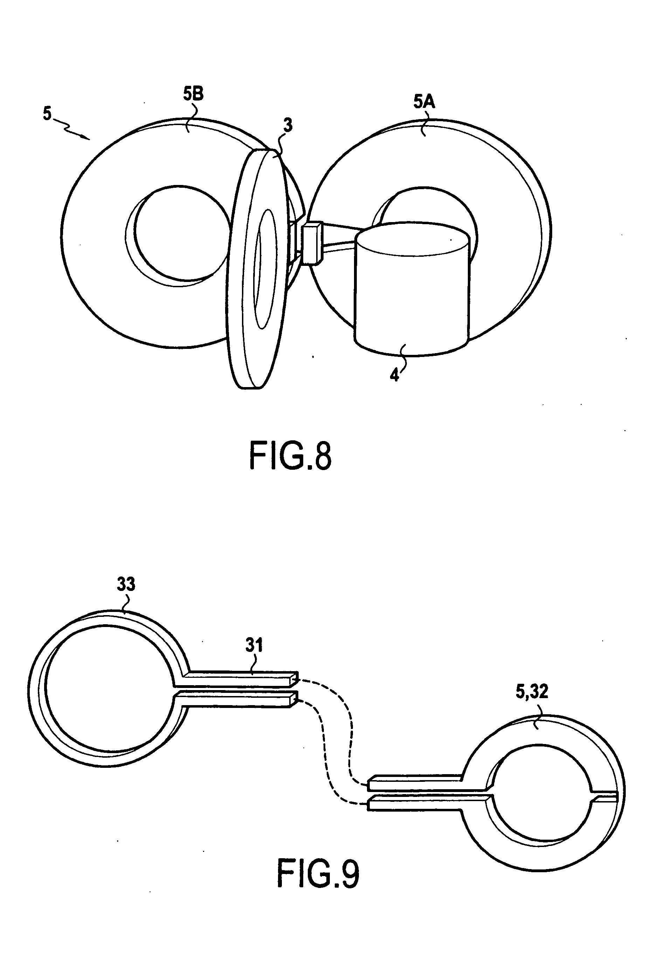

Dans le cas où l'on utilise un transformateur de flux 31, il est possible, comme représenté sur la Figure 9, de combiner le transformateur de flux/flux 31 et le transformateur de flux/champ du capteur hybride 5 en un seul objet. Le primaire 32 du transformateur de flux 31 est ainsi constitué par la boucle supraconductrice 71 du capteur hybride 5. Cette solution est avantageuse dans le cas où la taille du capteur hybride 5 et la taille de l'échantillon 4 sont comparables.

Sur la Figure 3, les modules 1 à 3 et 6 à 10 peuvent être tout à fait identiques aux modules correspondants du spectromètre RMN de la Figure 1 portant les mêmes références, de sorte que ces modules ne seront pas décrits à nouveau.

La Figure 4 montre une variante de réalisation selon laquelle plusieurs fréquences d'émission fₑ₁, fₑ₂, fₑ₃ sont utilisées. La bobine d'excitation est alors conçue à accord multiple.

Le dispositif d'excitation comprend des moyens d'émission à plusieurs canaux 1a, 1b, 1c pour émettre des impulsions radiofréquence de forte intensité avec une pluralité de fréquences d'émission prédéterminées fₑ₁, fₑ₂, fₑ₃ vers la bobine d'excitation 3 à accord multiple de façon à pouvoir être accordée sur l'une quelconque des fréquences d'émission prédéterminées.

Un capteur hybride 5 présente l'avantage d'être à large bande de sorte que la réception peut rester identique avec simplement un changement de fréquence de travail.

La Figure 8 montre un mode particulier de réalisation dans lequel le capteur hybride 5 double monté en gradiomètre comprend des premier et deuxième capteurs hybrides 5A, 5B disposés de telle manière que leurs axes de sensibilité soient disposés symétriquement par rapport à la bobine d'excitation 3 et perpendiculairement au champ créé par celle-ci. Le premier capteur hybride 5A est placé à proximité immédiate de l'échantillon 4. Le montage en gradiomètre permet de compenser partiellement les effets des impulsions, dès lors que les deux parties du gradiomètre voient de la même, façon la bobine d'excitation.

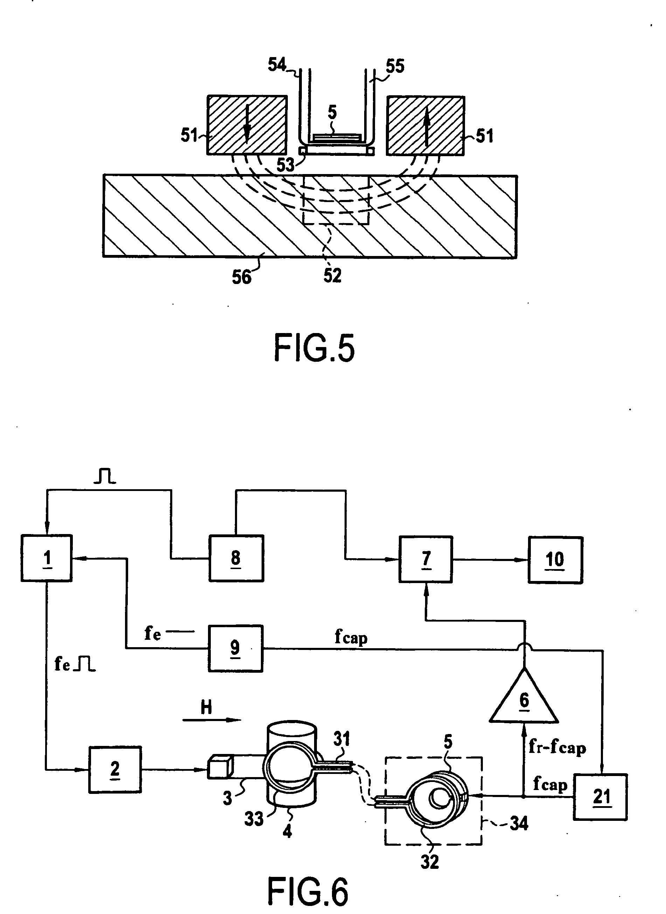

Le champ magnétique statique peut être créé par une bobine ou par des aimants permanents. Une utilisation possible des capteurs hybrides est le montage d'une détection de surface qui permet d'utiliser avantageusement la sensibilité du capteur. La figure 5 décrit un tel système.

Des aimants permanents 51 créent un champ magnétique connu dans un volume déterminé 52. Une bobine d'excitation 53 de surface induit une précession dans la zone déterminée. Le capteur hybride 5 permet de venir lire le signal de précession. Ce dernier est séparé de la surface 56 et de la bobine d'excitation 53 par une paroi 54 et un vide d'isolement 55. Un système de refroidissement basé soit sur des liquides cryogéniques, soit sur un système de cryogénérateur permet de refroidir le capteur afin de le maintenir en dessous de la température critique du supraconducteur.

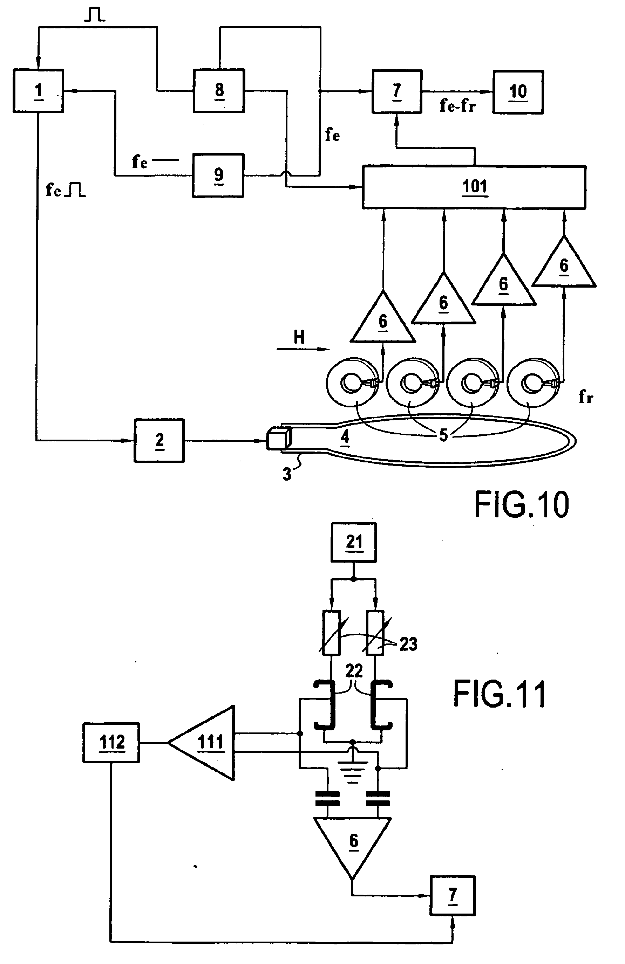

Dans le cas où l'imagerie par résonance est visée, il est possible de ne plus mettre en oeuvre un seul capteur hybride 5, mais plusieurs capteurs hybrides 5, chacun couvrant une zone de surface de mesure. Une telle configuration est représentée sur la Figure 10.

Dans ce cas là, on peut utiliser une seule boucle d'excitation 3 de taille suffisante et les capteurs 5 possèdent chacun leur étage de préamplification 6. La réception peut être dans ce cas multiplexée grâce à une commutation suffisamment rapide réalisée par un commutateur 101 piloté par le séquenceur 8.

Le champ magnétique H est créé, comme cela a été explicité en référence à la Figure 5, par des aimants permanents 51 qui sont préférentiellement en alliage de terre rare de type NdFeB ou SmCo afin de créer un champ magnétique suffisant. Des champs de l'ordre de 0.05T peuvent être ainsi créés. On ajuste finement la forme des aimants et leur position afin d'obtenir une homogénéité du champ statique dans la zone de mesure suffisante par rapport aux largeurs de raies de l'échantillon à mesurer. La fréquence de travail est donnée alors par le rapport gyromagnétique de l'espèce de noyau observée. La bobine d'excitation est aussi ajustée afin d'homogénéiser le champ radiofréquence dans la zone de travail. Les capteurs 5 sont mis parallèlement à la bobine d'excitation 53 le plus près possible de la surface 56 sachant qu'il faut une paroi de protection non métallique et un vide d'isolement suffisant pour que le capteur reste en dessous de sa température critique. La taille des capteurs est mise égale à la distance du capteur à la zone de mesure afin de minimiser le nombre de capteurs tout en ayant une résolution suffisante. Chaque capteur 5 est alimenté en courant alternatif afin d'avoir un signal de sortie à suffisamment basse fréquence pour pouvoir utiliser des multiplexeurs analogiques bas bruit.

La Figure 6 montre comment il est possible de mieux utiliser les propriétés des capteurs hybrides 5 en les alimentant avec un courant qui n'est plus continu mais à une fréquence f_{cap} différente de la fréquence d'émission fₑ. Cette fréquence f_{cap} est générée par la synthèse de fréquence 9 et envoyée à la source de courant 21. Dans ce cas, le signal détecté et amplifié sera égal à la somme ou à la différence de la fréquence de résonance fᵣ et de la fréquence du courant f_{cap}.

Cette dernière approche peut être particulièrement avantageuse en utilisant une fréquence de courant f_{cap} telle que la différence entre fréquence de courant f_{cap} et fréquence de résonance fᵣ soit constante. Dans ce cas, la partie réception du spectromètre de résonance peut être fortement simplifiée car elle fonctionne toujours à la même fréquence.

Dans le cadre d'applications médicales, la résonance magnétique à bas champ ou en champ terrestre peut être combinée avec l'imagerie magnétique qui mesure les signaux magnétiques émis par les courants circulant dans le corps humain dans la gamme courant continu-1KHz comme la magnéto-encéphalographie ou la magnéto-cardiographie. Imagerie magnétique et résonance magnétique peuvent être réalisées simultanément avec le même jeu de capteurs. En effet, la réponse des capteurs hybrides étant indépendante de la fréquence en dessous de plusieurs dizaines de MHz, on gardera la même sensibilité dans toute la gamme de mesure.

Une telle configuration est donnée en Figure 11. Chaque capteur magnétorésistif 22 de l'imageur est relié à la fois à un amplificateur RF 6 suivi d'un circuit de démodulation 7 pour la résonance magnétique comme présenté sur la Figure 7 mais en supplément, il est aussi connecté à un préamplificateur basse fréquence 111 suivi d'un filtre 112. Les capteurs magnétorésistifs 22 sont alimentés par une source de courant 21 continu ou alternatif. Si la source de courant est continue, le filtre 112 est un filtre passe-bas. Si la source de courant est alternative, le filtre est un filtre passe-bande centré sur la fréquence du courant.

## Revendications

1. Système de mesure d'un signal de résonance magnétique au sein d'un échantillon (4) placé dans un champ magnétique extérieur (H) statique, comprenant un dispositif d'excitation (1 à 3, 6 à 10) pour appliquer des impulsions radiofréquence de forte intensité à une fréquence d'émission prédéterminée fₑ dans une zone de mesure contenant l'échantillon (4), le dispositif d'excitation comprenant une bobine d'excitation (3) raccordée à ladite fréquence d'émission prédéterminée fₑ et disposée au voisinage de l'échantillon (4) de manière à émettre un champ électromagnétique essentiellement perpendiculaire au champ magnétique extérieur statique (H), et
au moins un capteur hybride supraconducteur-magnétorésistif (5) comprenant une boucle supraconductrice (71) munie d'une constriction (72) apte à augmenter significativement la densité du courant et au moins un capteur magnétorésistif (73) placé à proximité immédiate de ladite constriction (72), en étant séparé de celle-ci par un dépôt isolant (77), **caractérisé en ce que** ledit capteur magnétorésistif (73) et ladite constriction (72) sont recouverts d'au moins une couche (75) de matériau métallique non supraconducteur afin de servir de réservoir thermique et de réaliser une protection contre la destruction par des impulsions de radiofréquence, ladite au moins une couche (75) de matériau métallique non supraconducteur ne recouvrant que ladite constriction (72) et non le reste de la boucle supraconductrice (71).

2. Système selon la revendication 1, **caractérisé en ce que** le capteur hybride supraconducteur-magnétorésistif comprend au moins deux capteurs magnétorésistifs (22) montés en demi-pont de Wheatstone.

3. Système selon la revendication 2, **caractérisé en ce que** chaque paire de capteurs hybrides montés en demi-pont de Wheatstone est en outre connectée à un préamplificateur basse fréquence additionnel (111) lui-même connecté à un filtre (112), de manière à permettre d'effectuer, à l'aide des mêmes capteurs, une mesure de champ magnétique à fréquence faible à côté d'une mesure de résonance magnétique.

4. Système selon l'une quelconque des revendications 1 à 3, **caractérisé en ce que** chaque capteur magnétorésistif (73 ; 22) est alimenté par un courant alternatif à une fréquence prédéterminée f_{cap} différente de ladite fréquence d'émission prédéterminée fₑ.

5. Système selon la revendication 4, **caractérisé en ce que** la différence de fréquence entre la fréquence f_{cap} du courant appliqué à chaque capteur magnétorésistif (73 ; 22) et la fréquence fᵣ de résonance de l'échantillon (4) est constante.

6. Système selon l'une quelconque des revendications 1 à 5, **caractérisé en ce que** le capteur hybride (5) est placé directement au voisinage de l'échantillon (4).

7. Système selon la revendication 6, **caractérisé en ce que** le capteur hybride (5) est placé de telle sorte que son axe de sensibilité soit perpendiculaire au champ émis par ladite bobine d'excitation (3).

8. Système selon l'une quelconque des revendications 1 à 5, **caractérisé en ce que** le capteur hybride (5) est couplé à l'échantillon (4) au moyen d'un transformateur de flux (31).

9. Système selon la revendication 8, **caractérisé en ce que** le transformateur de flux (31) est au moins partiellement supraconducteur.

10. Système selon la revendication 8 ou la revendication 9, **caractérisé en ce que** le transformateur de flux (31) comprend une boucle secondaire (33) qui entoure l'échantillon (4) ou est disposée à proximité immédiate de l'échantillon (4).

11. Système selon l'une quelconque des revendications 8 à 10, **caractérisé en ce que** le transformateur de flux (31) comprend une boucle secondaire (33) qui est placée perpendiculairement à la bobine d'excitation (3).

12. Système selon l'une quelconque des revendications 8 à 11, **caractérisé en ce que** le transformateur de flux (31) comprend une boucle primaire (32) qui est placée parallèlement à la boucle supraconductrice du capteur hybride (5) et présente une taille équivalente à celle-ci.

13. Système selon les revendications 9 et 12, **caractérisé en ce que** ladite boucle primaire (32) et ladite boucle supraconductrice du capteur hybride (5) sont disposées dans une enceinte refroidie (34).

14. Système selon l'une quelconque des revendications 8 à 11, **caractérisé en ce que** le transformateur de flux (31) comprend une boucle primaire (32) qui est constituée directement par la boucle supraconductrice du capteur hybride (5).

15. Système selon l'une quelconque des revendications 1 à 5, **caractérisé en ce qu'**il comprend un capteur hybride (5) double monté en gradiomètre comportant des premier et deuxième capteurs hybrides (5A, 5B) de telle sorte que leurs axes de sensibilité soient disposés symétriquement par rapport à la bobine d'excitation (3) et perpendiculairement au champ créé par celle-ci, et l'un (5A) des premier et deuxième capteurs hybrides (5A, 5B) étant placé à proximité immédiate de l'échantillon (4).

16. Système selon l'une quelconque des revendications 1 à 15, **caractérisé en ce que** le dispositif d'excitation (1 à 3, 6 à 10) comprend des moyens d'émission à plusieurs canaux (1a, 1b, 1c) pour émettre des impulsions radiofréquence de forte intensité avec une pluralité de fréquences d'émission prédéterminées fₑ₁, fₑ₂, fₑ₃ vers la bobine d'excitation (3) qui est du type à accord multiple de façon à pouvoir être accordée sur l'une quelconque desdites fréquences d'émission prédéterminées fₑ₁, fₑ₂, fₑ₃.

17. Système selon l'une quelconque des revendications 1 à 5, **caractérisé en ce que** l'échantillon est constitué par une surface (56) en regard de laquelle sont disposés des aimants permanents (51) pour créer ledit champ magnétique statique (H) dans un volume déterminé (52), **en ce que** la bobine d'excitation (53) est disposée parallèlement à ladite surface (56) au voisinage dudit volume déterminé (52), et **en ce que** le capteur hybride (5) est disposé au voisinage de ladite bobine d'excitation (53), parallèlement à celle-ci, en étant séparé de celle-ci par une paroi (54) et un espace vide d'isolement (55).

18. Système selon l'une quelconque des revendications 1 à 17, **caractérisé en ce que** ledit dispositif d'excitation (1 à 3, 6 à 10) comprend un dispositif de synthèse de fréquence (9) pour émettre un signal radiofréquence à une fréquence d'émission fₑ, un séquenceur (8) pour émettre des impulsions de hachage du signal radiofréquence, un module d'émission (1) relié au dispositif de synthèse de fréquence (9) et au séquenceur (8) pour émettre lesdites impulsions radiofréquence de forte intensité avec ladite fréquence d'émission prédéterminée fₑ, un circuit de protection (2) pour appliquer lesdites impulsions à la bobine d'excitation (3), un préamplificateur (6) recevant le signal à la fréquence de résonance fr très proche de la fréquence d'émission fₑ, capté par le capteur hybride (5), un circuit de démodulation (7) recevant d'une part les impulsions émises à la fréquence d'émission fₑ à partir du séquenceur (8) et du dispositif de synthèse de fréquence (9) et d'autre part les impulsions reçues à la fréquence de résonance fᵣ délivrées par le pré-amplificateur (6), et un dispositif d'acquisition (10) pour récupérer un signal de sortie à la fréquence fₑ-fᵣ.

19. Système selon l'une quelconque des revendications 1 à 18, **caractérisé en ce qu'**il comprend une pluralité de capteurs hybrides (5).

20. Système selon la revendication 19, **caractérisé en ce qu'**il comprend une bobine d'excitation (3) unique et **en ce que** chaque capteur hybride (5) coopère avec un préamplificateur individuel (6).

21. Système selon l'une quelconque des revendications 1 et 4 à 20, **caractérisé en ce que** chaque capteur hybride est en outre connecté à un préamplificateur basse fréquence additionnel (111) lui-même connecté à un filtre (112), de manière à permettre d'effectuer à l'aide des mêmes capteurs une mesure de champ magnétique à fréquence faible à côté d'une mesure de résonance magnétique.

22. Système selon la revendication 3 ou la revendication 21, **caractérisé en ce que** les capteurs magnétorésistifs (22) des capteurs hybrides sont alimentés en courant continu et **en ce que** le filtre (112) est un filtre passe-bas.

23. Système selon la revendication 3 ou la revendication 21, **caractérisé en ce que** les capteurs magnétorésistifs (22) des capteurs hybrides sont alimentés en courant alternatif et **en ce que** le filtre (112) est un filtre passe-bande centré sur la fréquence dudit courant alternatif.

24. Système selon l'une quelconque des revendications 1 à 23, **caractérisé en ce que** les capteurs magnétorésistifs (73 ; 22) des capteurs hybrides (5) sont choisis parmi les capteurs à effet Hall, les capteurs à magnétorésistance anisotrope, les capteurs à magnétorésistance géante, les capteurs à magnétorésistance tunnel, les capteurs à magnétorésistance colossale.

25. Procédé de mesure d'un signal de résonance magnétique au sein d'un échantillon (4) placé dans un champ magnétique extérieur statique (H), selon lequel on applique des impulsions radiofréquence de forte intensité à une fréquence d'émission prédéterminée fₑ, dans une zone de mesure contenant l'échantillon (4), à une bobine d'excitation (3) accordée à ladite fréquence d'émission prédéterminée fₑ et disposée au voisinage de l'échantillon (4) de manière à émettre un champ électromagnétique essentiellement perpendiculaire au champ magnétique extérieur statique (H), et
on détecte un signal de résonance magnétique à l'aide d'au moins un capteur hybride supraconducteur-magnétorésistif (5) comprenant une boucle supraconductrice (71) munie d'au moins une constriction (72) et au moins un capteur magnétorésistif (73) placé à proximité immédiate de ladite constriction (72) en étant séparé de celle-ci par une couche isolante (77), **caractérisé en ce que** ledit capteur magnétorésistif (73) et ladite constriction (72) sont recouverts d'au moins une couche (75) de matériau métallique non supraconducteur afin de servir de réservoir thermique et de réaliser une protection contre la destruction par des impulsions de radiofréquence, ladite au moins une couche (75) de matériau métallique non supraconducteur ne recouvrant que ladite constriction (72) et non le reste de la boucle supraconductrice (71).

## Claims

1. A system for measuring a magnetic resonance signal in a sample (4) placed in a static external magnetic field (H), including an excitation device (1 to 3, 6 to 10) for applying high-intensity radio-frequency pulses at a predetermined emission frequency fₑ in a measurement zone containing the sample (4), the excitation device including an excitation coil (3) tuned to said predetermined emission frequency fₑ and disposed in the vicinity of the sample (4) to emit an electromagnetic field essentially perpendicular to the static external magnetic field (H), and
one superconductive-magnetoresistive hybrid sensor (5) including a superconductive loop (71) having a constriction (72) adapted to increase significantly the current density and at least a magnetoresistive sensor (73) placed in the immediate vicinity of said constriction (72), separated therefrom by an insulative deposit (77), **characterized in that** said magnetoresistive sensor (73) and said constriction (72) are covered with at least one layer (75) of non-superconductive metal to serve as a heat sink and to provide protection against destruction by radio-frequency pulses, said at least one layer (75) of non-supraconductive metal covering only said constriction (72) and not covering the rest of the superconductive loop (71).

2. A system according to claim 1, **characterized in that** the superconductive-magnetoresistive hybrid sensor includes at least two magnetoresistive sensors (22) in a Wheatstone half-bridge configuration.

3. A system according to claim 2, **characterized in that** each pair of hybrid sensors in a Wheatstone half-bridge configuration is also connected to an additional low-frequency preamplifier (111) itself connected to a filter (112) to enable a magnetic field measurement at low frequency to be effected at the same time as a magnetic resonance measurement by the same sensors.

4. A system according to any one of claims 1 to 3, **characterized in that** each magnetoresistive sensor (73; 22) is supplied with power by an AC supply at a predetermined frequency f_{cap} different from said predetermined emission frequency fₑ.

5. A system according to claim 4, **characterized in that** the difference between the frequency f_{cap} of the current supplied to the magnetoresistive sensor (73; 22) and the resonant frequency fᵣ of the sample (4) is constant.

6. A system according to any one of claims 1 to 5, **characterized in that** the hybrid sensor (5) is directly in the vicinity of the sample (4).

7. A system according to claim 6, **characterized in that** the hybrid sensor (5) is located in such a manner that its sensitivity axis is perpendicular to the field emitted by said excitation coil (3).

8. A system according to any one of claims 1 to 5, **characterized in that** the hybrid sensor (5) is coupled to the sample (4) by a flux transformer (31).

9. A system according to claim 8, **characterized in that** the flux transformer (31) is at least partially superconductive.

10. A system according to claim 8 or claim 9, **characterized in that** the flux transformer (31) includes a secondary loop (33) that surrounds the sample (4) or is disposed in the immediate vicinity of the sample (4).

11. A system according to any one of claims 8 to 10, **characterized in that** the flux transformer (31) includes a secondary loop (33) perpendicular to the excitation coil (3).

12. A system according to any one of claims 8 to 11, **characterized in that** the flux transformer (31) includes a primary loop (32) which is parallel to the superconductive loop of the hybrid sensor (5) and has a size equivalent thereto.

13. A system according to claims 9 and 12, **characterized in that** said primary loop (32) and said superconductive loop of the hybrid sensor (5) are placed in a cooled enclosure (34).

14. A system according to any one of claims 8 to 11, **characterized in that** the flux transformer (31) includes a primary loop (32) that consists of the superconductive loop of the hybrid sensor (5).

15. A system according to any one of claims 1 to 5, **characterized in that** it includes a dual hybrid sensor (5) configured as a gradiometer including first and second hybrid sensors (5A, 5B) with their sensitivity axes symmetrical relative to the excitation coil (3) and perpendicular to the field created thereby, one (5A) of the first and second hybrid sensors (5A, 5B) being in the immediate vicinity of the sample (4).

16. A system according to any one of claims 1 to 15, **characterized in that** the excitation device (1 to 3, 6 to 10) includes multichannel emission means (1a, 1b, 1c) for emitting high-intensity radio-frequency pulses at predetermined emission frequencies fₑ₁, fₑ₂, fₑ₃ toward the excitation coil (3) that is of the multiple tuning type so that it can be tuned to any of said predetermined emission frequencies fₑ₁, fₑ₂, fₑ₃.

17. A system according to any one of claims 1 to 5, **characterized in that** the sample is a surface (56) facing permanent magnets (51) for creating said static magnetic field (H) in a particular volume (52), the excitation coil (53) is parallel to said surface (56) in the vicinity of said particular volume (52), and the hybrid sensor (5) is in the vicinity of said excitation coil (53) and parallel thereto, being separated therefrom by a wall (54) and an insulative empty space (55).

18. A system according to any one of claims 1 to 17, **characterized in that** said excitation device (1 to 3, 6 to 10) includes a frequency synthesizer (9) for emitting a radio-frequency signal at an emission frequency fₑ, a sequencer (8) for emitting pulses for chopping the radio-frequency signal, an emission module (1) connected to the frequency synthesizer (9) and to the sequencer (8) to emit said high-intensity radio-frequency pulses at said predetermined emission frequency fₑ, a protection circuit (2) for applying said pulses to the excitation coil (3), a preamplifier (6) for receiving the signal at the resonant frequency fᵣ very close to the emission frequency fₑ captured by the hybrid sensor (5), a demodulator circuit (7) for receiving both the pulses at the emission frequency fₑ from the sequencer (8) and the frequency synthesizer (9) and also the pulses received at the resonant frequency fᵣ from the preamplifier (6), and an acquisition device (10) for recovering an output signal at the frequency fₑ-fᵣ.

19. A system according to any one of claims 1 to 18, **characterized in that** it includes a plurality of hybrid sensors (5).

20. A system according to claim 19, **characterized in that** it includes a single excitation coil (3) and each hybrid sensor (5) cooperates with an individual preamplifier (6).

21. A system according to any one of claims 1 and 4 to 20, **characterized in that** each hybrid sensor is further connected to an additional low-frequency preamplifier (111) itself connected to a filter (112) to enable a magnetic field measurement at low frequency to be effected at the same time as a magnetic resonance measurement by the same sensors.

22. A system according to claim 3 or claim 21, **characterized in that** the magnetoresistive sensors (22) of the hybrid sensors are supplied with power by a direct current supply and the filter (112) is a low-pass filter.

23. A system according to claim 3 or claim 21, **characterized in that** the magnetoresistive sensors (22) of the hybrid sensors are supplied with power by an alternating current supply and the filter (112) is a band-pass filter centered on the frequency of said alternating current.

24. A system according to any one of claims 1 to 23, **characterized in that** the magnetoresistive sensors (73, 22) of the hybrid sensors (5) are chosen from Hall-effect sensors, anisotropic magnetoresistance sensors, giant magnetoresistance sensors, tunnel magnetoresistance sensors, and colossal magnetoresistance sensors.

25. A method of measuring a magnetic resonance signal in a sample (4) placed in a static external magnetic field (H), wherein high-intensity radio-frequency pulses are applied at a predetermined emission frequency fₑ in a measurement zone containing the sample (4) to an excitation coil (3) tuned to said predetermined emission frequency fₑ and disposed in the vicinity of the sample (4) so as to emit an electromagnetic field essentially perpendicular to the static external magnetic field (H), a magnetic resonance signal is detected by a least one superconductive magnetoresistive hybrid sensor (5) including a superconductive loop (71) including a constriction (72) and at least one magnetoresistive sensor (73) placed in the immediate vicinity of said constriction (72) and separated therefrom by an insulative layer (77), **characterized in that** said magnetoresistive sensor (73) and said constriction (72) are covered by at least one layer (75) of non-superconductive metal in order to serve as a heat sink and to provide protection against destruction by radio-frequency pulses, said at least one layer (75) of non-superconductive metal covering only said constriction (72) and not covering the rest of the superconductive loop (71).

## Patentansprüche

1. System zur Messung eines Magnetresonanzsignals innerhalb einer Probe (4), die in einem statischen äußeren Magnetfeld (H) angeordnet ist, umfassend eine Erregervorrichtung (1 bis 3, 6 bis 10) zum Anlegen von Hochfrequenzimpulsen von hoher Intensität mit einer vorbestimmten Sendefrequenz fₑ in einem die Probe (4) enthaltenden Meßbereich, wobei die Erregervorrichtung eine Erregerspule (3) umfaßt, die mit der vorbestimmten Sendefrequenz fₑ verbunden und in der Nähe der Probe (4) angeordnet ist, derart, daß sie ein zu dem statischen äußeren Magnetfeld (H) im wesentlichen senkrechtes elektromagnetisches Feld aussendet, und
wenigstens einen supraleitenden-magnetoresistiven Hybridsensor (5), der eine supraleitende Schleife (71), welche mit einer Einschnürung (72) versehen ist, die geeignet ist, die Dichte des Stroms signifikant zu erhöhen, sowie wenigstens einen magnetoresistiven Sensor (73) umfaßt, der in unmittelbarer Nähe der Einschnürung (72) angeordnet und dabei durch einen isolierenden Überzug (77) von dieser getrennt ist, **dadurch gekennzeichnet, daß** der magnetoresistive Sensor (73) und die Einschnürung (72) mit wenigstens einer Schicht (75) aus nicht supraleitendem metallischem Material überzogen sind, um als Wärmespeicher zu dienen und um einen Schutz gegen die Zerstörung durch Hochfrequenzimpulse auszubilden, wobei die wenigstens eine Schicht (75) aus nicht supraleitendem metallischem Material lediglich die Einschnürung (72) und nicht den Rest der supraleitenden Schleife (71) bedeckt.

2. System nach Anspruch 1, **dadurch gekennzeichnet, daß** der supraleitendemagnetoresistive Hybridsensor wenigstens zwei zu einer halben Wheatstone-Brücke geschaltete magnetoresistive Sensoren (22) umfaßt.

3. System nach Anspruch 2, **dadurch gekennzeichnet, daß** jedes Paar von zu einer halben Wheatstone-Brücke geschalteten Hybridsensoren ferner mit einem zusätzlichen Niederfrequenz-Vorverstärker (111) verbunden ist, der seinerseits mit einem Filter (112) verbunden ist, so daß ermöglicht wird, mit Hilfe der gleichen Sensoren eine Niederfrequenzmagnetfeldmessung neben einer Magnetresonanzmessung durchzuführen.

4. System nach einem der Ansprüche 1 bis 3, **dadurch gekennzeichnet, daß** jeder magnetoresistive Sensor (73; 22) mit einem Wechselstrom mit einer vorbestimmten Frequenz f_{cap} gespeist wird, die sich von der vorbestimmten Sendefrequenz fₑ unterscheidet.

5. System nach Anspruch 4, **dadurch gekennzeichnet, daß** der Frequenzunterschied zwischen der Frequenz f_{cap} des an jeden magnetoresistiven Sensor (73; 22) angelegten Stroms und der Resonanzfrequenz fᵣ der Probe (4) konstant ist.

6. System nach einem der Ansprüche 1 bis 5, **dadurch gekennzeichnet, daß** der Hybridsensor (5) direkt in der Nähe der Probe (4) angeordnet ist.

7. System nach Anspruch 6, **dadurch gekennzeichnet, daß** der Hybridsensor (5) derart angeordnet ist, daß seine Empfindlichkeitsachse zu dem durch die Erregerspule (3) ausgesandten Feld senkrecht verläuft.

8. System nach einem der Ansprüche 1 bis 5, **dadurch gekennzeichnet, daß** der Hybridsensor (5) mittels eines Flußtransformators (31) mit der Probe (4) gekoppelt ist.

9. System nach Anspruch 8, **dadurch gekennzeichnet, daß** der Flußtransformator (31) wenigstens teilweise supraleitend ist.

10. System nach Anspruch 8 oder Anspruch 9, **dadurch gekennzeichnet, daß** der Flußtransformator (31) eine Sekundärschleife (33) umfaßt, welche die Probe (4) umgibt oder in unmittelbarer Nähe der Probe (4) angeordnet ist.

11. System nach einem der Ansprüche 8 bis 10, **dadurch gekennzeichnet, daß** der Flußtransformator (31) eine Sekundärschleife (33) umfaßt, die zu der Erregerspule (3) senkrecht angeordnet ist.

12. System nach einem der Ansprüche 8 bis 11, **dadurch gekennzeichnet, daß** der Flußtransformator (31) eine Primärschleife (32) umfaßt, die zu der supraleitenden Schleife des Hybridsensors (5) parallel angeordnet ist und eine zu dieser äquivalente Größe aufweist.

13. System nach den Ansprüchen 9 und 12, **dadurch gekennzeichnet, daß** die Primärschleife (32) und die supraleitende Schleife des Hybridsensors (5) in einem gekühlten Raum (34) angeordnet sind.

14. System nach einem der Ansprüche 8 bis 11, **dadurch gekennzeichnet, daß** der Flußtransformator (31) eine Primärschleife (32) umfaßt, die direkt von der supraleitenden Schleife des Hybridsensors (5) gebildet ist.

15. System nach einem der Ansprüche 1 bis 5, **dadurch gekennzeichnet, daß** es einen als Gradiometer angeordneten doppelten Hybridsensor (5) umfaßt, der einen ersten und einen zweiten Hybridsensor (5A, 5B) aufweist, derart, daß ihre Empfindlichkeitsachsen zu der Erregerspule (3) symmetrisch und zu dem durch diese erzeugten Feld senkrecht angeordnet sind, und wobei der eine (5A) der ersten und zweiten Hybridsensoren (5A, 5B) in unmittelbarer Nähe der Probe (4) angeordnet ist.

16. System nach einem der Ansprüche 1 bis 15, **dadurch gekennzeichnet, daß** die Erregervorrichtung (1 bis 3, 6 bis 10) Sendemittel mit mehreren Kanälen (1 a, 1 b, 1 c) umfaßt, um Hochfrequenzimpulse von hoher Intensität mit einer Vielzahl von vorbestimmten Sendefrequenzen fₑ₁, fₑ₂, fₑ₃ in Richtung der Erregerspule (3) zu senden, welche vom Typ mit Mehrfachabstimmung ist, so daß sie auf eine beliebige der vorbestimmten Sendefrequenzen fₑ₁, fₑ₂, fₑ₃ abgestimmt werden kann.

17. System nach einem der Ansprüche 1 bis 5, **dadurch gekennzeichnet, daß** die Probe von einer Fläche (56) gebildet ist, der gegenüber Permanentmagneten (51) angeordnet sind, um das statische Magnetfeld (H) in einem bestimmten Raum (52) zu erzeugen, daß die Erregerspule (53) zu der Fläche (56) in der Nähe des bestimmten Raumes (52) parallel angeordnet ist, und daß der Hybridsensor (5) in der Nähe der Erregerspule (53), parallel zu dieser angeordnet und dabei durch eine Wand (54) und einen Isolationshohlraum (55) von dieser getrennt ist.

18. System nach einem der Ansprüche 1 bis 17, **dadurch gekennzeichnet, daß** die Erregervorrichtung (1 bis 3, 6 bis 10) eine Frequenzsynthesevorrichtung (9), um ein Hochfrequenzsignal mit einer Sendefrequenz fₑ zu senden, einen Sequenzer (8), um Impulse zum Zerhacken des Hochfrequenzsignals zu senden, ein Sendemodul (1), das mit der Frequenzsynthesevorrichtung (9) und mit dem Sequenzer (8) verbunden ist, um die Hochfrequenzimpulse von hoher Intensität mit der vorbestimmten Sendefrequenz fₑ zu senden, einen Schutzkreis (2) zum Anlegen der Impulse an die Erregerspule (3), einen Vorverstärker (6), welcher das durch den Hybridsensor (5) erfaßte Signal mit der Resonanzfrequenz fᵣ sehr nahe der Sendefrequenz fₑ empfängt, einen Demodulationskreis (7), der einerseits die von dem Sequenzer (8) und der Frequenzsynthesevorrichtung (9) mit der Sendefrequenz fₑ ausgesandten Impulse und andererseits die durch den Vorverstärker (6) gelieferten, mit der Resonanzfrequenz fᵣ empfangenen Impulse empfängt, sowie eine Erfassungsvorrichtung (10) zur Gewinnung eines Ausgangssignals mit der Frequenz fₑ-fᵣ umfaßt.

19. System nach einem der Ansprüche 1 bis 18, **dadurch gekennzeichnet, daß** es eine Vielzahl von Hybridsensoren (5) umfaßt.

20. System nach Anspruch 19, **dadurch gekennzeichnet, daß** es eine einzige Erregerspule (3) umfaßt und daß jeder Hybridsensor (5) mit einem individuellen Vorverstärker (6) zusammenwirkt.

21. System nach einem der Ansprüche 1 und 4 bis 20, **dadurch gekennzeichnet, daß** jeder Hybridsensor ferner mit einem zusätzlichen Niederfrequenz-Vorverstärker (111) verbunden ist, der seinerseits mit einem Filter (112) verbunden ist, so daß ermöglicht wird, mit Hilfe der gleichen Sensoren eine Niederfrequenzmagnetfeldmessung neben einer Magnetresonanzmessung durchzuführen.

22. System nach Anspruch 3 oder Anspruch 21, **dadurch gekennzeichnet, daß** die magnetoresistiven Sensoren (22) der Hybridsensoren mit Gleichstrom gespeist werden und daß das Filter (112) ein Tiefpaßfilter ist.

23. System nach Anspruch 3 oder Anspruch 21, **dadurch gekennzeichnet, daß** die magnetoresistiven Sensoren (22) der Hybridsensoren mit Wechselstrom gespeist werden und daß das Filter (112) ein um die Frequenz des Wechselstroms zentriertes Bandpaßfilter ist.

24. System nach einem der Ansprüche 1 bis 23, **dadurch gekennzeichnet, daß** die magnetoresistiven Sensoren (73; 22) der Hybridsensoren (5) aus den Hall-Sensoren, den Sensoren mit anisotropem Magnetowiderstand, den Giant-Magnetoresistance-Sensoren, den Tunnel-Magnetowiderstand-Sensoren, den Sensoren mit kolossalem Magnetowiderstand ausgewählt sind.

25. Verfahren zur Messung eines Magnetresonanzsignals innerhalb einer Probe (4), die in einem statischen äußeren Magnetfeld (H) angeordnet ist, wobei Hochfrequenzimpulse von hoher Intensität mit einer vorbestimmten Sendefrequenz fₑ in einem die Probe (4) enthaltenden Meßbereich an eine Erregerspule (3) angelegt werden, die auf die vorbestimmte Sendefrequenz fₑ abgestimmt und in der Nähe der Probe (4) angeordnet ist, derart, daß sie ein zu dem statischen äußeren Magnetfeld (H) im wesentlichen senkrechtes elektromagnetisches Feld aussendet, und
ein Magnetresonanzsignal mit Hilfe wenigstens eines supraleitenden-magnetoresistiven Hybridsensors (5) erfaßt wird, der eine supraleitende Schleife (71), welche mit wenigstens einer Einschnürung (72) versehen ist, sowie wenigstens einen magnetoresistiven Sensor (73) umfaßt, der in unmittelbarer Nähe der Einschnürung (72) angeordnet und dabei durch eine isolierende Schicht (77) von dieser getrennt ist, **dadurch gekennzeichnet, daß** der magnetoresistive Sensor (73) und die Einschnürung (72) mit wenigstens einer Schicht (75) aus nicht supraleitendem metallischem Material überzogen sind, um als Wärmespeicher zu dienen und um einen Schutz gegen die Zerstörung durch Hochfrequenzimpulse auszubilden, wobei die wenigstens eine Schicht (75) aus nicht supraleitendem metallischem Material lediglich die Einschnürung (72) und nicht den Rest der supraleitenden Schleife (71) bedeckt.
